# DEMANDE DE BREVET EUROPEEN

(11) **EP 1 248 261 A2**
(43) Date de publication de la demande: **09.10.2002**
(21) Numéro de dépôt: 02354028.9
(22) Date de dépôt: 11.02.2002
(51) Int. Cl.: G11C 7/10

(54) **Procédé de gestion à accès aléatoire et rapide d'une mémoire dram**

(30) Priorité: 13.02.2001 FR 0101934
(71) Demandeur: STMicroelectronics S.A., 92120 Montrouge (FR)
(72) Inventeur: Harrand, Michel, 38120 Saint Egreve (FR); Bulone, Joseph, 38530 La Buissiere (FR)
(74) Mandataire: de Beaumont, Michel

(57) **Abrégé**

L'invention concerne un procédé de gestion à accès rapide et aléatoire d'une mémoire de type DRAM, comprenant les étapes suivantes :
diviser la mémoire en blocs mémoire (21) accessibles indépendamment en lecture et en écriture ;
identifier l'adresse (@b) du bloc concerné par une requête courante ;
comparer l'adresse du bloc concerné par une requête courante aux adresses des N-1 blocs antérieurement requis, N étant un nombre entier de cycles nécessaire à l'exécution d'une requête ; et
si l'adresse du bloc concerné par une requête courante est égale à l'adresse d'un bloc correspondant à l'une des N-1 requêtes antérieures, suspendre et mémoriser la requête courante jusqu'à exécution de la requête antérieure visant le même bloc, sinon l'exécuter.

## Description

La présente invention concerne la gestion d'une mémoire RAM dynamique (DRAM).

Il est généralement connu que, quand on veut une mémoire à accès très rapide, on utilise une mémoire RAM statique (SRAM). Toutefois, une telle mémoire occupe une surface relativement importante puisqu'il faut 6 à 8 transistors pour constituer une cellule mémoire élémentaire.

Par contre, les mémoires RAM dynamiques (DRAM) ont des surfaces pouvant être beaucoup plus petites, chaque cellule élémentaire comprenant essentiellement un transistor et un élément capacitif.

Toutefois, on recherche souvent à réaliser une mémoire ayant à la fois la faible surface d'une mémoire DRAM et les caractéristiques de rapidité d'une mémoire SRAM. On cherche par exemple à réaliser une mémoire monopuce de 144 Mbits avec une possibilité d'accès à chaque cycle d'une horloge d'une période de 6,4 ns (fréquence de l'ordre de 150 MHz).

La limitation fondamentale d'une mémoire DRAM est que le temps d'accès en lecture ou en écriture d'une telle mémoire occupe plusieurs cycles d'horloge, typiquement quatre cycles d'horloge. Ceci essentiellement pour tenir compte des phases de précharge avant chaque lecture ou écriture d'une donnée et de réécriture après chaque lecture d'une donnée ainsi que pour tenir compte des temps de commutation relativement longs des amplificateurs de lecture d'une telle mémoire dus au faible niveau de signal disponible.

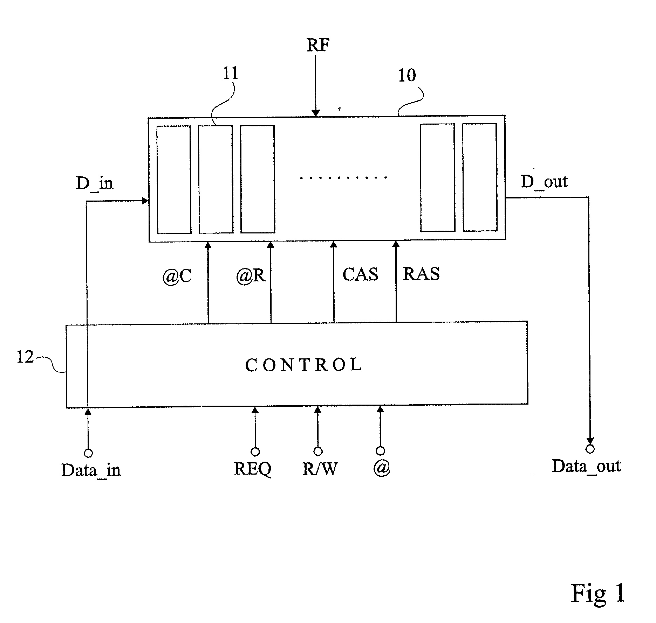

Le schéma général d'un système utilisant une mémoire DRAM par l'intermédiaire d'un contrôleur de mémoire est illustré très schématiquement en figure 1.

Une mémoire DRAM 10 comprend un grand nombre de blocs élémentaires 11 et doit être associée à des décodeurs de lecture et d'écriture (non représentés). Quand un utilisateur (ou un programme utilisateur) veut accéder à la mémoire 10, il doit fournir au moins quatre indications :
- une indication R/W indiquant qu'il souhaite lire ou écrire dans la mémoire,
- une indication d'adresse @ pour indiquer à quelle cellule de la mémoire il veut accéder,
- une indication Data_in ou D_in des données qu'il veut écrire (quand il souhaite un accès en écriture), et
- un signal de requête REQ pour valider l'ordre d'accès.

Dans le cas où l'accès à la mémoire est un accès en lecture, des données seront fournies sur un bus de sortie Data_out ou D_out.

En outre la mémoire doit être périodiquement rafraîchie et reçoit une commande de rafraîchissement RF.

Les indications R/W, @, REQ et D_in sont fournies à un bloc de contrôle 12 qui transmet les données à écrire et qui transforme les données d'entrée essentiellement en des données de validation d'accès à une rangée (RAS ou Row Access Strobe), de validation d'accès à une colonne (CAS ou Column Access Strobe), d'adresse de rangée (@R), et d'adresse de colonne (@C).

En outre la mémoire doit être périodiquement rafraîchi et reçoit une commande de rafraîchissement RF.

En fait, on commence par réaliser un adressage de rangée et c'est une opération qui prend un certain temps. Ensuite, une fois que l'on est sur une rangée donnée, il est possible d'accéder au rythme de l'horloge à divers éléments de la même rangée. Cette propriété est souvent utilisée pour permettre d'accéder rapidement à des DRAM en groupant convenablement les données d'entrée en fonction des sorties auxquelles on s'attend de façon que ces données se trouvent préférentiellement successivement sur une même ligne (que les mots recherchés soient dans une même page).

On s'intéresse ici au cas où la position des données auxquelles on veut successivement accéder est totalement aléatoire et dans lequel il n'est pas possible de pré-grouper ces données dans une même page. C'est le cas par exemple d'applications de communication sur des réseaux de communication rapides tels que le réseau Internet.

Ainsi, un objet de la présente invention est de prévoir un mode de gestion à accès rapide en lecture et en écriture d'une mémoire DRAM compatible en particulier avec le cas où le positionnement dans la mémoire de données successives est complètement aléatoire, c'est-à-dire qu'il n'est pas possible de disposer à l'avance les données dans la mémoire et/ou les ordres de lecture et d'écriture de façon que les données successives auxquelles on veut accéder se situent dans une même page (sur une même rangée). La présente invention vise aussi une architecture de mémoire permettant un tel mode de gestion.

Pour atteindre cet objet, la présente invention prévoit un procédé de gestion à accès rapide et aléatoire d'une mémoire de type DRAM, comprenant les étapes suivantes :
diviser la mémoire en blocs mémoire accessibles indépendamment en lecture et en écriture ;
identifier l'adresse du bloc concerné par une requête courante ;
comparer l'adresse du bloc concerné par une requête courante aux adresses des N-1 blocs antérieurement requis, N étant un nombre entier de cycles nécessaire à l'exécution d'une requête ; et
si l'adresse du bloc concerné par une requête courante est égale à l'adresse d'un bloc correspondant à l'une des N-1 requêtes antérieures, suspendre et mémoriser la requête courante jusqu'à exécution de la requête antérieure visant le même bloc, sinon l'exécuter.

Selon un mode de réalisation de la présente invention, l'opération de suspension consiste à empiler les requêtes dans une mémoire du type premier-entré/premier-sorti.

Selon un mode de réalisation de la présente invention, pour la lecture des données, le procédé comprend en outre les étapes suivantes :
mémoriser dans un registre FIFO de sortie les données lues pendant les M premiers cycles d'utilisation de la mémoire ; et
fournir une donnée de sortie du registre FIFO, M cycles après chaque requête de lecture.

Selon un mode de réalisation de la présente invention, la mémoire est rafraîchie périodiquement ligne par ligne et bloc par bloc, et le procédé comprend l'étape consistant à comparer l'adresse du bloc à rafraîchir aux adresses de N-1 requêtes en cours et des N requêtes suivantes et à différer le rafraîchissement si l'adresse du bloc à rafraîchir correspond à l'une des adresses de bloc de ces 2N-1 requêtes.

Selon un mode de réalisation de la présente invention, le procédé comprend les étapes consistant à reprendre le rafraîchissement et interrompre la succession des requêtes après qu'un nombre déterminé d'interruption de cycles de rafraîchissement a eu lieu.

Selon un mode de réalisation de la présente invention, le procédé comprend les étapes suivantes :
mémoriser N requêtes suivant la requête courante ;
si l'exécution de la requête courante est suspendue, exécuter l'une des requêtes suivantes non en conflit avec la requête en cours d'exécution ; et
si la requête exécutée est une requête de lecture, réordonner les informations lues dans l'ordre des requêtes de lecture exécutées.

Selon un mode de réalisation de la présente invention, les blocs mémoire sont répartis en deux ensembles accessibles en parallèle, d'où il résulte que chaque ensemble n'a statistiquement à traiter que la moitié des requêtes.

Selon un mode de réalisation de la présente invention, les blocs mémoire sont répartis en plusieurs groupes, les blocs d'un même groupe partageant le même bus, et deux requêtes peuvent être émises simultanément vers deux groupes distincts.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 illustre une organisation possible d'une mémoire DRAM associée à un contrôleur ;
la figure 2 illustre l'organisation d'une mémoire DRAM selon la présente invention ;
la figure 3 est un chronogramme illustrant le procédé de gestion selon la présente invention ;
la figure 4 illustre une variante de mise en oeuvre du procédé selon la présente invention ;
la figure 5 est un organigramme illustrant le fonctionnement du dispositif de la figure 4 ;
la figure 6 représente une autre variante de réalisation de la présente invention ;
la figure 7 représente une autre variante de réalisation de la présente invention ; et
la figure 8 représente une autre variante de réalisation de la présente invention.

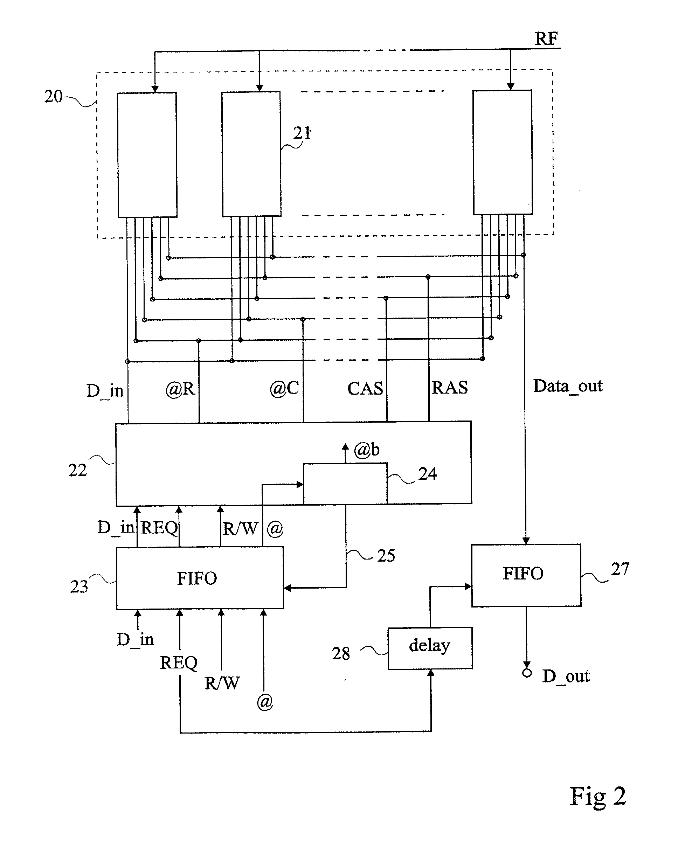

Comme l'illustre la figure 2, une mémoire 20 de type DRAM selon la présente invention est divisée en un grand nombre de blocs (banks) de cellules mémoire, chaque bloc 21 étant associé à un décodeur d'adresse (non représenté), c'est-à-dire que chaque bloc est couplé à un bus d'entrée de données Data_in, à un bus de sortie de données Data_out, à une entrée de validation d'adresse de rangée RAS, à une entrée de validation d'adresse de colonne CAS, à une entrée d'adresse de rangée @R, et à une entrée d'adresse de colonne @C. Les signaux de commande des bus sont fournis par un contrôleur 22 qui reçoit des signaux D_in, REQ, R/W et @ d'un utilisateur ou d'un programme utilisateur par l'intermédiaire d'un registre du type premier-entré/premier-sorti (FIFO) 23.

Le contrôleur 22 comprend un bloc 24 destiné à déterminer à partir d'une adresse d'entrée @ à quel bloc 21 appartient la cellule mémoire correspondante, de façon à coupler à ce bloc les bus susmentionnés. Cette adresse est appelée adresse de bloc et chaque adresse d'entrée est décomposée en une adresse de bloc @b, et en une adresse de rangée @R et une adresse de colonne @C à l'intérieur du bloc déterminé.

Selon la présente invention, on utilise en outre le bloc 24 pour, lorsqu'une nouvelle adresse est requise par l'utilisateur, comparer l'adresse du bloc concerné aux N-1 adresses de bloc précédentes, N étant le nombre de cycles nécessaires pour exécuter une instruction de lecture ou d'écriture. La sortie de comparaison 25 est renvoyée au registre FIFO 23 pour y bloquer la dernière instruction et les instructions suivantes tant que l'adresse de bloc située en tête du registre FIFO ne peut être traitée.

Le registre FIFO 23 doit être d'une taille suffisante pour contenir des instructions successives pour former tampon dans le cas où plusieurs instructions désignant des blocs déjà utilisés sont envoyées à la suite. Par exemple, si dix instructions concernant le même bloc sont envoyées séquentiellement, et que la durée de traitement d'une instruction est de quatre cycles, le tampon devra pouvoir contenir trente instructions successives.

On comprendra que le registre FIFO se revidera à chaque fois qu'à un cycle une instruction n'est pas envoyée, ce qui est couramment désigné par les informaticiens comme l'envoi d'une instruction de non opération (Nop).

En fait, le registre FIFO 23 pourra avoir une taille relativement limitée puisque, si la mémoire est par exemple divisée en 64 blocs et que la durée de traitement d'une instruction est de quatre cycles, la probabilité pour qu'un accès tombe dans un bloc non déjà occupé est de (1-3/64)100 = 95%.

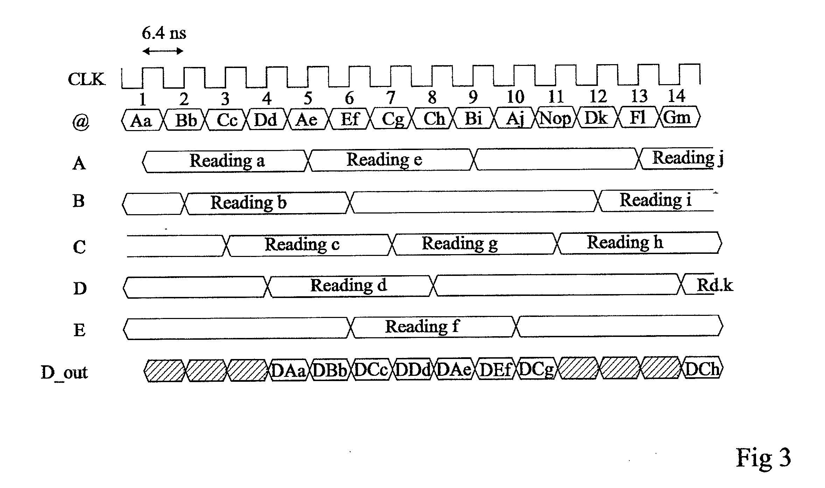

La façon dont fonctionne une mémoire selon la présente invention est mieux illustrée en relation avec la figure 3. La première ligne représente des cycles d'impulsions d'horloge CLK numérotés de 1 à 14. La deuxième ligne représente l'adresse visée @, la première lettre (en majuscule) indiquant l'adresse d'un bloc et la deuxième lettre (en minuscule) indiquant l'adresse d'une cellule à l'intérieur d'un bloc. Les lignes suivantes représentent les états de cinq blocs de mémoire A, B, C, D, E dans lesquels des lectures doivent être faites. La dernière ligne représente les données de sortie D_out. On suppose que l'on requiert successivement des lectures aux adresses Aa, Bb, Cc, Dd, Ae, Ef, Cg, Ch, Bi, Aj, Nop (aucune opération), Dk, Fl, Gm.

Au premier cycle d'horloge, l'adresse Aa est demandée et la lecture à l'adresse a du bloc A commence. Le bloc A est occupé par cette opération de lecture à l'adresse a (reading a) pendant quatre cycles.

Au deuxième cycle, on commence une lecture dans le bloc B.

Au troisième cycle, on commence une lecture dans le bloc C.

Au quatrième cycle, on commence une lecture dans le bloc D.

Au cinquième cycle, on cherche à lire l'adresse e, à nouveau dans le bloc A. Ceci est possible puisque quatre cycles se sont écoulés depuis que l'on a recherché l'adresse a dans le bloc A. Le bloc A est donc disponible et la lecture de l'adresse e commence dans le bloc A.

Au sixième cycle, on commence une lecture à l'adresse f du bloc E.

Au septième cycle, on commence une lecture à l'adresse g du bloc C.

Un problème se pose au cycle 8 où on requiert l'adresse h du bloc C alors que l'adresse g du bloc C a déjà été demandée au cycle 7. On suspend alors le fonctionnement du système et la lecture de l'adresse h du bloc C ne commence qu'au cycle 11 (trois cycles après le moment où cette lecture a été demandée). Pendant ce temps les requêtes sont stockées dans la FIFO 23.

Ensuite, dans l'exemple donné, les autres opérations dans le bloc A, le bloc D, le bloc F puis le bloc G se déroulent sans difficultés. On notera qu'au cycle 11 aucune opération n'a été demandée ce qui est désigné par l'indication Nop. Ainsi, au cycle 11, alors que l'on commence la lecture de l'adresse h du bloc C, trois instructions sont stockées dans le registre FIFO 23 mais, du fait qu'à ce cycle aucune instruction n'a été demandée, seules deux instructions vont être stockées.

La ligne D_out montre qu'à la fin du cycle 4, on lit la donnée DAa. On obtient ensuite successivement sur la borne D_out les données DBb, DCc, DDd, DAe, DEf et DCg. Mais c'est seulement quatre cycles après la lecture de la donnée DCg que l'on peut lire la donnée DCh puisque des instructions successives de lecture dans le bloc C sont arrivées au moment des cycles 7 et 8.

Ainsi, la prévision de décodeurs de lecture/écriture associés à chacun des blocs de la mémoire DRAM, en association avec le registre FIFO 23 permet de donner à la mémoire DRAM selon l'invention une instruction de lecture ou d'écriture par cycle d'horloge, l'exécution des instructions étant suspendue si plusieurs requêtes s'adressent au même bloc. Comme on l'a noté, ceci n'entraîne pas que la bascule FIFO d'entrée se remplit indéfiniment, puisqu'elle se revide chaque fois que, lors d'un cycle d'horloge, aucune requête (Nop) n'est adressée.

C'est là le premier objet de l'invention. Toutefois, l'invention prévoit d'autres aspects permettant d'améliorer encore le fonctionnement du système.

Dans le cas où des séquences d'accès à des données d'un même bloc se rencontreraient fréquemment, c'est-à-dire un cas d'accès non réellement aléatoire, on peut prévoir de transformer l'adresse de bloc par une combinaison de bits d'adresse obtenus au moyen de OU Exclusifs afin d'obtenir des séquences d'adresses "pseudo-aléatoires".

### 1. Obtention d'une latence constante

Dans certaines applications, il importe peu qu'il y ait un décalage plus ou moins long entre une demande de lecture en mémoire et une sortie de la donnée lue. Ce qui importe, c'est que les données lues sortent séquentiellement au rythme auquel elles ont été demandées. Pour cela, la présente invention prévoit d'ajouter un registre 27 du type premier-entré/premier-sorti (FIFO) (figure 2) à la sortie de données. On commence par remplir ce registre. Il se videra ensuite au rythme de l'horloge tandis que de nouvelles données lues viendront le remplir. Un dispositif de liaison entre le registre FIFO d'entrée et le registre FIFO de sortie assure que le registre FIFO de sortie fournit une sortie avec un décalage d'un certain nombre de coups d'horloge après une requête de lecture, mais que la sortie est inhibée si aucune instruction de lecture n'est envoyée en entrée lors de la requête correspondant à ce décalage. Pour cela, il suffira de prévoir en liaison avec chaque signal de requête une validation du registre FIFO de sortie avec un décalage correspondant au nombre de cycles de remplissage initial du registre. Ce décalage est illustré en figure 2 par un bloc (delay) 28.

### 2. Mécanisme de rafraîchissement

Une mémoire de type DRAM nécessite de réaliser périodiquement sur chaque cellule ou plutôt sur chaque rangée une opération de rafraîchissement. Ceci présente l'inconvénient qu'il peut y avoir un conflit entre le rafraîchissement en cours et une requête de lecture ou d'écriture demandée. La présente invention propose une solution pour résoudre ce conflit sans perdre de temps de cycle.

Pour cela, la présente invention prévoit de disposer à l'entrée du circuit de contrôle, à la sortie du registre FIFO 23 un registre à décalage.

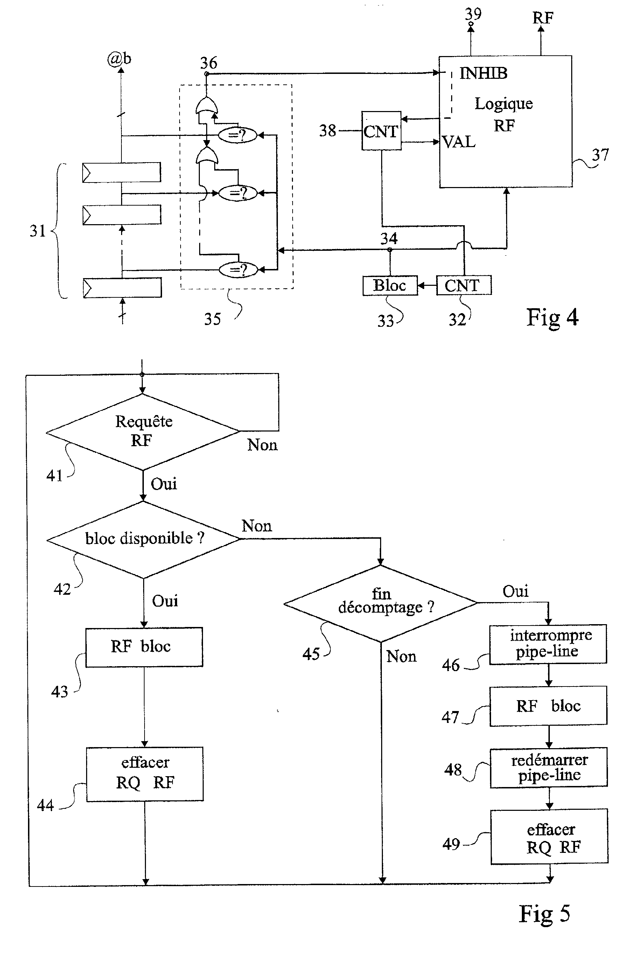

En figure 4, ce registre à décalage est désigné par la référence 31 et comprend par exemple 2N-1 étages si le temps d'exécution d'une instruction est de N cycles d'horloge. Ce registre comprendra en particulier les adresses des blocs correspondant aux requêtes successives.

Le rafraîchissement est déterminé par un compteur 32 qui incrémente un numéro de bloc 33 et un numéro de page pour fournir des adresses de bloc RFbloc et de page RFpage à rafraîchir. Le numéro de bloc accessible sur un bus 34 est comparé à tous les numéros de bloc présents dans le registre 31 par un comparateur 35 dont la sortie 36 indique si le numéro du bloc que l'on souhaite rafraîchir est l'un des blocs qui est en cours d'adressage ou qui doit être adressé pendant les N prochains cycles. Si la sortie indique qu'il y a une coïncidence, un bloc logique de rafraîchissement 37 reçoit un signal d'inhibition (INHIB) du rafraîchissement. Le rafraîchissement est alors suspendu tant que le conflit demeure. Quand la requête d'un bloc posant problème est exécutée, le rafraîchissement reprend et une requête de rafraîchissement RF est fournie par le bloc logique 37.

En outre, le système comprend un mécanisme de sécurité pour éviter que le rafraîchissement soit interrompu pendant une période trop longue si jamais le conflit demeurait trop longtemps, c'est-à-dire si plusieurs requêtes successives étaient adressées vers le bloc que l'on souhaite rafraîchir à l'instant considéré. Ce système de sécurité comprend un compteur 38 qui est mis en route au rythme du compteur 32 dès qu'un signal INHIB apparaît. Quand le compteur 38 atteint un comptage prédéterminé correspondant à la durée maximum pendant laquelle il est tolérable d'interrompre un rafraîchissement, un signal de validation VAL est fourni au circuit logique 37 et ce bloc fournit un signal 39 qui interrompt le déroulement du système et des divers pipelines pour opérer le rafraîchissement. Les opérations de lecture/écriture reprennent après que ce rafraîchissement a été effectué.

Ainsi, le bloc logique 37 associé au compteur 38 effectue les opérations suivantes illustrées en figure 5. A une étape initiale 41, on vérifie si une requête de rafraîchissement (RF) provient du compteur 32. Si oui, en 42, on vérifie si le bloc à rafraîchir est disponible. Si oui, on opère le rafraîchissement en 43 puis, en 44, on efface la requête de rafraîchissement et on revient à l'étape 41. Si à l'étape 42 on voit qu'un signal INHIB est présent, c'est-à-dire que le bloc à rafraîchir n'est pas disponible, on déclenche, en 45, le compteur 38. Si le comptage de ce compteur n'a pas atteint un seuil déterminé, la boucle revient à l'étape 41. Si le comptage est expiré, la logique de traitement fournit, à l'étape 46, sur une sortie 39, un ordre d'interruption du pipeline c'est-à-dire que le déroulement du processus de requêtes en mémoire est interrompu. A l'étape 47, on opère le rafraîchissement du bloc considéré. A l'étape 48, on redémarre le pipeline. A l'étape 49 on interrompt la requête de rafraîchissement puis on revient à l'étape 41. Le bloc logique 37 pourra être un circuit câblé à une logique programmée.

### 3. Exécution dans le désordre de requêtes d'accès en mémoire

En considérant le chronogramme de la figure 3, on voit que, au cycle 8, quand la requête Ch non exécutable immédiatement est appelée, cette requête est suivie des requêtes Bi et Aj qui pourraient être exécutées immédiatement, les blocs B et A étant libres aux instants où ces requêtes apparaissent.

Selon un aspect de la présente invention, on prévoit de commencer immédiatement l'exécution des requêtes B et A au moment où elles apparaissent puis de lancer l'exécution de la requête dans le bloc C seulement après. Bien entendu, pour que, en sortie, ceci ne dérègle pas le système, on prévoira un registre de réordonnancement qui recevra l'information selon laquelle l'ordre d'exécution des requêtes en entrée a été modifiée pour les refournir en sortie dans l'ordre où elles ont été demandées.

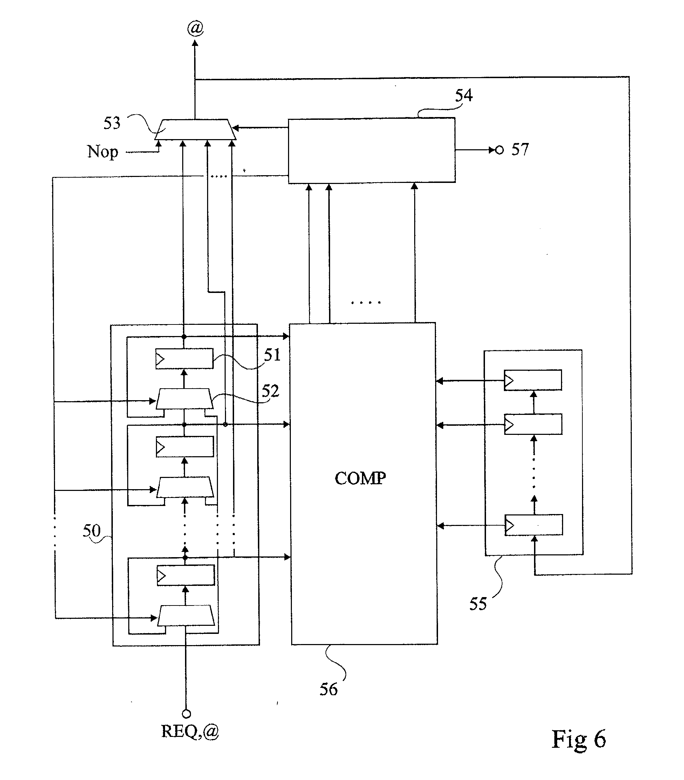

Le système représenté en figure 6 stocke dans un registre 50 les Q requêtes qui suivent la dernière requête à exécuter. Ces requêtes sont placées dans le registre 51 dans leur ordre d'arrivée selon le mode normal de fonctionnement d'un registre à décalage. Dans le registre 50, un multiplexeur 52 est disposé en amont de chacun des étages 51. Les étages 51 et les multiplexeurs 52 sont connectés de sorte que la sortie de l'un quelconque des étages 51 puisse être sélectionnée par un multiplexeur 53 dont la sortie permet de commander l'exécution de la requête correspondante. Les multiplexeurs 52 et 53 sont commandés par un bloc logique 54.

Un registre 55 reçoit la sortie du multiplexeur 53 et mémorise les N requêtes en cours d'exécution. On vérifie dans un bloc de Q x N comparateurs 56 (similaire au comparateur 35 de la figure 4) si le contenu de chacun des étages du registre à décalage 50 correspond au contenu de l'un des étages du registre 55. Cette information est envoyée au bloc logique 54 qui commande les multiplexeurs 52 et 53 de façon à exécuter successivement les requêtes correspondant au contenu des étages du registre 50 dans l'ordre du premier registre dont le contenu ne correspond pas à un bloc mémorisé dans le registre 55. Le circuit logique 54 assure de façon classique d'autres fonctions nécessaires au bon fonctionnement du système et comporte notamment une sortie 57 de commande du registre de réordonnancement susmentionné.

Quand une requête ultérieure est exécutée avant une requête antérieure qui correspond à un bloc occupé, cette requête est éliminée du pipeline. Les requêtes non sélectionnées disposées avant celles qui ont été sélectionnées restent à leur position et les requêtes non sélectionnées disposées après la requête sélectionnée sont décalées d'une unité en position du pipeline. Ceci est effectué en commandant de façon adéquate les multiplexeurs 52 disposés entre chaque étage 51 du registre 50. La conception d'un circuit logique 54 pour réaliser ces fonctions est à la portée de l'homme de l'art qui pourra obtenir ce résultat par des moyens de circuits câblés ou par une logique programmée.

Les multiplexeurs associés à la logique de commande permettent également de reremplir les registres supérieurs du pipeline à partir du registre FIFO au cas où le registre FIFO est resté vide pendant certains cycles d'horloge parce qu'aucune requête n'a été introduite.

Le seul cas où un cycle d'horloge ne peut pas être utilisé est celui où les Q accès suivants (incluant l'accès en cours) font tous appel à des blocs utilisés.

Ainsi, la probabilité de ne pas pouvoir utiliser un cycle courant est égal à [(N-1)/P]^{Q} et la probabilité de succès est égal à 1-[(N-1)/P]^{Q}.

### 4. Utilisation conjointe de deux mémoires

D'autres mémoires DRAM du type décrit précédemment pourront être utilisées conjointement avec la moitié du nombre de blocs prévus précédemment dans chacune de ces mémoires de manière à conserver une capacité totale inchangée, en prévoyant deux registres FIFO d'entrée. Dans ce cas, en moyenne, la moitié des requêtes est envoyée à chaque mémoire. Ceci donne la possibilité de vider facilement le registre FIFO d'entrée associé à chacune des mémoires dans le cas où il a commencé à se remplir. Ainsi, la rapidité ou bande passante du système est doublée. Plus précisément, la bande passante utilisable de chaque mémoire devient celle correspondant à la moitié du nombre de blocs et la bande passante de la mémoire d'ensemble est double.

### 5. Mémoire à deux entrées

Le système décrit ci-dessus ne fonctionne que si la bande passante de la mémoire n'est pas utilisée à 100%, c'est-à-dire si l'on rencontre des absences de requête (Nop) de temps en temps. Sinon, le registre FIFO d'entrée se remplirait à la longue. L'amélioration décrite ci-après permet au système de fonctionner même si une requête valide est présente à chaque cycle d'horloge (aucun Nop). Le principe est que l'on permet au registre FIFO d'entrée de se vider plus vite qu'il ne se remplit en exécutant, lorsque cela est possible, deux accès à la mémoire par cycle d'horloge. Cette amélioration permet de réduire le taux de perte de données à moins de 10⁻¹⁰ par cycle.

Selon une autre amélioration de la présente invention, la mémoire est divisée en plusieurs groupes de blocs. Les blocs d'un même groupe partagent le même bus. Chaque groupe utilise un bus différent des autres groupes. Le système pourrait fonctionner, de manière d'ailleurs plus efficace, avec un bloc par groupe, mais le routage des bus occuperait alors une surface très importante. On choisit donc le découpage en groupe de blocs selon un compromis efficacité/surface. Un système de commande permet d'exécuter deux accès en parallèle, pourvu que les accès appartiennent à des groupes de blocs différents. Le système utilise un mécanisme similaire à celui décrit au point 2 ci-dessus en relation avec un mécanisme de rafraîchissement pour sélectionner deux requêtes dans le pipeline parmi les requêtes qui n'utilisent pas un bloc déjà utilisé. La sélection du second accès utilise, en plus des critères déjà décrits, le fait que le second accès ne doit pas être dans le même groupe de blocs que le premier. Tout le système de commande utilise une horloge à fréquence double pour lire deux requêtes à partir du registre FIFO tandis qu'une requête est introduite.

La mémoire est partagée en G groupes de blocs. Les différents blocs d'un groupe partagent les mêmes bus d'adresse et de données.

On peut adresser simultanément deux blocs différents si et seulement s'ils n'appartiennent pas au même groupe (un seul bus par groupe). Plus il y a de groupes, plus il faut d'interconnexions mais plus il est probable que l'on puisse exécuter deux accès en parallèle.

Par exemple, une mémoire de 32 blocs peut être organisée en deux groupes de seize blocs, en quatre groupes de huit blocs ou en huit groupes de quatre blocs. L'organisation en quatre groupes de huit blocs sera probablement le meilleur compromis entre les performances et la complexité (nombre d'interconnexions).

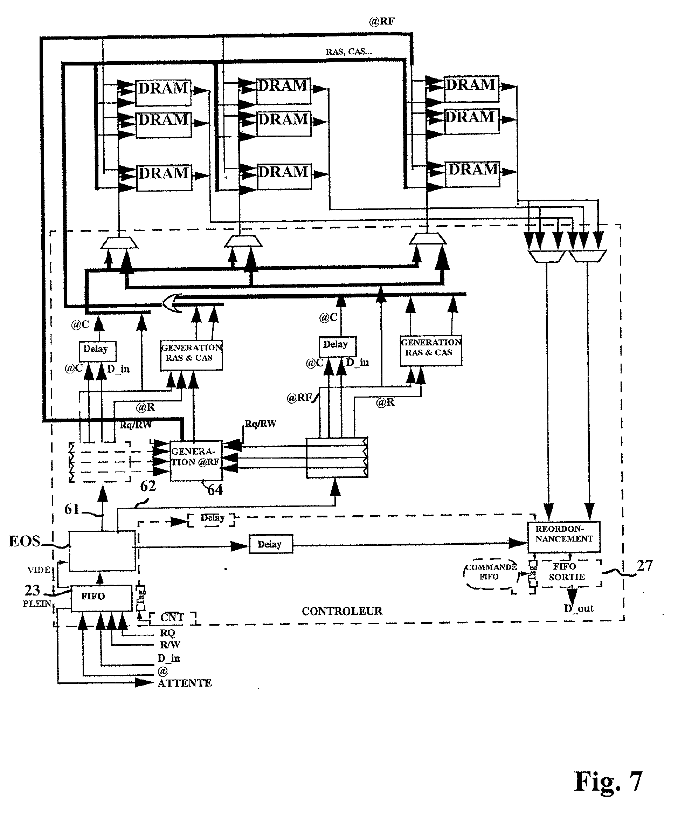

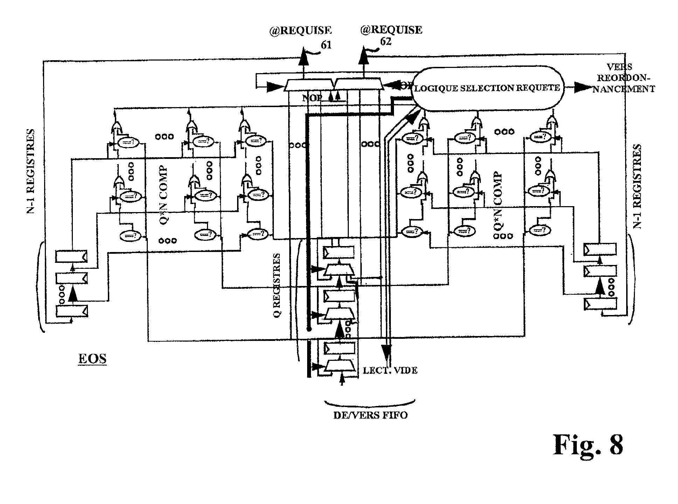

Comme l'illustre la figure 7, les requêtes d'accès en mémoire sont mémorisées dans le registre FIFO d'entrée 23 à chaque cycle d'horloge principal (fréquence F). Un circuit logique de sélection d'ordre d'exécution (EOS), plus particulièrement représenté en figure 8 et actionné à la fréquence 2F par une horloge secondaire, lit un maximum de deux requêtes à partir du registre FIFO tant que le registre FIFO n'est pas vide et qu'il y a suffisamment de place dans ses Q registres de requête.

Lors de l'initialisation du système, en supposant qu'une requête d'accès est introduite dans le registre FIFO à chaque cycle d'horloge principal, l'EOS lit une requête dans le registre FIFO à chaque cycle principal (il ne peut pas en lire deux étant donné que le registre FIFO est vidé chaque fois qu'il lit une requête) et la mémorise dans l'un des Q registres.

Des multiplexeurs entre les registres du pipeline permettent à l'EOS de remplir directement les registres de niveau supérieur à partir du registre FIFO pour ne pas à avoir à attendre plusieurs cycles d'horloge pour reremplir le pipeline quand le registre FIFO a été vidé en raison de l'absence de requête. Ces multiplexeurs permettent également d'éliminer des pipelines une requête qui a été sélectionnée (ceci a été décrit précédemment en relation avec le registre 51 de la figure 6).

L'EOS comporte deux sorties de requête 61 et 62 pour exécuter simultanément deux accès dans la mémoire. Pour chacune d'elles, à chaque cycle d'horloge principal, l'EOS sélectionne une requête à partir des Q qui sont dans ces registres. Dans ce but, les adresses des blocs de toutes les Q requêtes sont comparées aux adresses de blocs de toutes les requêtes qui sont couramment traitées. Le nombre maximum de ces requêtes en cours est égal à 2(N-1), étant donné qu'une requête est exécutée en N cycles et que deux requêtes peuvent être exécutées simultanément.

Lors de l'initialisation ou lors de la première requête exécutée après que le pipeline EOS a été effacé, le contenu des 2(N-1) registres est invalidé.

L'algorithme de sélection de requêtes exécuté par la logique de commande EOS en ce qui concerne sa sortie gauche 61 est la suivante :
- si l'adresse d'un bloc de la requête située en haut du registre Q n'est pas égale à l'adresse de l'un quelconque des accès en cours, cette requête est sélectionnée pour être sortie à gauche ;
- sinon, si la condition est satisfaite pour le suivant des Q registres, cette requête est sélectionnée, et ainsi de suite ;
- sinon, si la condition est satisfaite pour le dernier des Q registres, cette requête est sélectionnée ;
- sinon, aucune requête n'est sélectionnée lors de ce cycle d'horloge principal.

L'algorithme de sélection de requête exécuté par la logique de commande EOS pour sa sortie droite 62 est identique sauf que l'on ajoute la condition suivante à la condition que la requête ne vise pas un bloc déjà en cours d'utilisation :
- la requête choisie pour la sortie droite ne doit pas adresser un bloc du même groupe que celui qui est adressé par la sortie gauche.

Chacune des deux sorties de l'EOS est envoyée au bloc de génération de rafraîchissement 64 qui sélectionne des blocs qui peuvent être rafraîchis et le moment de le faire sans interférer avec les accès en mémoire, comme on l'a exposé précédemment. Alors, les requêtes sont transférées à la mémoire après génération des signaux RAS et CAS. Chaque sortie du pipeline peut être envoyée à l'un quelconque des G blocs par l'intermédiaire des G multiplexeurs (on rappellera que l'EOS a sélectionné ses sorties de façon qu'elles visent des blocs distincts) .

Dans la plupart des cas, l'EOS pourra exécuter immédiatement toutes les requêtes qui sont lues à partir du registre FIFO de sorte que l'EOS lira une seule requête du registre FIFO lors de chaque cycle d'horloge principal au lieu de deux, car le registre FIFO sera vidé à chaque cycle.

Quand plusieurs requêtes consécutives (ou presque consécutives) visent le même bloc, dans la plupart des cas, l'EOS pourra réordonner ces requêtes de façon qu'au moins une requête puisse être exécutée à chaque cycle d'horloge principal.

Toutefois, il peut arriver que le nombre de requêtes consécutives (ou presque consécutives) visant le même bloc soit trop élevé (c'est-à-dire supérieur à Q) pour permettre à l'EOS de trouver des requêtes exécutables à chaque cycle d'horloge. Dans ce cas, une seule requête pour n cycles d'horloge (n ≤ N) sera exécutée. Alors, il arrivera qu'aucun des Q registres ne sera libre. L'EOS ne pourra pas lire une requête dans le registre FIFO, et si des requêtes incidentes continuent à arriver, le registre FIFO se remplira. Toutefois, cette situation durera jusqu'au moment où les requêtes adressent à nouveau des blocs différents. Alors, l'EOS pourra lire et exécuter deux requêtes à partir du registre FIFO à chaque cycle d'horloge. Le registre FIFO se videra donc à nouveau et l'activité normale d'une requête par cycle et d'une seule requête dans le registre FIFO reprendra.

Les divers éléments des figures 7 et 8 n'ont été décrits que de façon très sommaire. Ceci a été fait pour alléger la description. Ces figures, qui seront facilement comprises par l'homme de l'art, seront considérées comme faisant partie intégrante de la présente description.

Bien entendu, diverses variantes pourront être apportées à la présente invention, notamment en ce qui concerne les tailles des divers blocs.

L'invention peut également s'appliquer à des mémoires autres que des mémoires DRAM fonctionnant sur le même principe d'exécution d'une requête en plusieurs cycles d'horloge.

## Revendications

1. Procédé de gestion à accès rapide et aléatoire d'une mémoire de type DRAM, **caractérisé en ce qu'**il comprend les étapes suivantes :
diviser la mémoire en blocs mémoire (21) accessibles indépendamment en lecture et en écriture ;
identifier l'adresse (@b) du bloc concerné par une requête courante ;
comparer l'adresse du bloc concerné par une requête courante aux adresses des N-1 blocs antérieurement requis, N étant un nombre entier de cycles nécessaire à l'exécution d'une requête ; et
si l'adresse du bloc concerné par une requête courante est égale à l'adresse d'un bloc correspondant à l'une des N-1 requêtes antérieures, suspendre et mémoriser la requête courante jusqu'à exécution de la requête antérieure visant le même bloc, sinon l'exécuter.

2. Procédé selon la revendication 1, **caractérisé en ce que** l'opération de suspension consiste à empiler les requêtes dans une mémoire du type premier-entré/premier-sorti (FIFO 23).

3. Procédé de gestion à accès rapide d'une mémoire DRAM selon la revendication 1, **caractérisé en ce que**, pour la lecture des données, il comprend en outre les étapes suivantes :
mémoriser dans un registre FIFO de sortie (27) les données lues pendant les M premiers cycles d'utilisation de la mémoire ; et
fournir une donnée de sortie du registre FIFO, M cycles après chaque requête de lecture.

4. Procédé de gestion à accès rapide d'une mémoire DRAM selon la revendication 1, dans lequel la mémoire est rafraîchie périodiquement ligne par ligne et bloc par bloc, **caractérisé en ce qu'**il comprend l'étape consistant à comparer l'adresse du bloc à rafraîchir aux adresses de N-1 requêtes en cours et des N requêtes suivantes et à différer le rafraîchissement si l'adresse du bloc à rafraîchir correspondant à l'une des adresses de bloc de ces 2N-1 requêtes.

5. Procédé de gestion à accès rapide d'une mémoire DRAM selon la revendication 4, **caractérisé en ce qu'**il comprend les étapes consistant à reprendre le rafraîchissement et interrompre la succession des requêtes après qu'un nombre déterminé d'interruption de cycles de rafraîchissement a eu lieu.

6. Procédé de gestion à accès rapide d'une mémoire DRAM selon la revendication 1, **caractérisé en ce qu'**il comprend les étapes suivantes :
mémoriser N requêtes suivant la requête courante ;
si l'exécution de la requête courante est suspendue, exécuter l'une des requêtes suivantes non en conflit avec la requête en cours d'exécution ; et
si la requête exécutée est une requête de lecture, réordonner les informations lues dans l'ordre des requêtes de lecture exécutées.

7. Procédé de gestion à accès rapide d'une mémoire DRAM selon la revendication 1, **caractérisé en ce que** les blocs mémoire sont répartis en deux ensembles accessibles en parallèle, d'où il résulte que chaque ensemble n'a statistiquement à traiter que la moitié des requêtes.

8. Procédé de gestion à accès rapide d'une mémoire DRAM selon la revendication 1, **caractérisé en ce que** les blocs mémoire sont répartis en plusieurs groupes, les blocs d'un même groupe partageant le même bus, et **en ce que** deux requêtes peuvent être émises simultanément vers deux groupes distincts.
